# EUROPEAN PATENT SPECIFICATION

(11) **EP 0 660 443 B1**
(45) Date of publication and mention of the grant of the patent: **22.10.1997**
(21) Application number: 95200108.9
(22) Date of filing: 05.05.1992
(51) Int. Cl.: H01R 9/09, H01R 13/04

(54) **Electrical connector**
Elektrischer Verbinder
Connecteur électrique

(30) Priority: 17.05.1991 US 701929; 17.05.1991 US 703433
(43) Date of publication of application: 28.06.1995
(62) Divisional of application: 92304040.6
(73) Proprietor: THE WHITAKER CORPORATION, Wilmington, Delaware 19808 (US)
(72) Inventor: Kile, Richard Allen, Hummelstown, Pennsylvania 17036 (US); Locati, Ronald Peter, Harrisburg, Pennsylvania 17111 (US); Messick, James Harrison, Gastonia, North Carolina 28056 (US); Myers, Leonard Jerry, Kings Mountain, North Carolina 28086 (US)
(74) Representative: Warren, Keith Stanley

(56) References cited:
- EP-A- 0 232 103
- FR-A- 2 450 510
- US-A- 4 557 549
- US-A- 4 679 890

## Description

This invention relates to electrical connectors of the type having a connector body and a plurality of posts extending out of one side of the connector body for mounting to a circuit board. In particular, this invention relates to an improved tip geometry on the posts of the connector.

US-A-4 847 588 discloses an electrical connector with a retention feature in which the posts of the connector are offset in the form of a crimp to create frictional forces against the side wall of the through hole of the circuit board onto which the electrical connector is mounted. The disclosed retention feature relies entirely on friction, and does not provide any latching force tending to secure the electrical connector in position on the circuit board.

In another type of retention feature for electrical connectors individual pins of the connector are formed to create a latching force against the bottom surface of the circuit board on which the electrical connector is mounted. See for example US-A-3 524 108 and JP-U-57-86270. Such below the board retention features can provide an audible click when the connector is seated on the circuit board, and some users regard below the board retention features as more stable.

When below the board retention features are applied to relatively stiff posts such as posts having a cross sectional dimension of 0.0635 by 0.0635 cm (0.025 by 0.025 inches) problems have been encountered. These problems relate to the fact that the through hole geometry of the circuit board varies within a range of tolerances, and the retention feature must function properly throughout this range. In a below the board retention feature the corners of the post latch against the corner of the through hole. In the past, there has been a tendency with relatively thick and inflexible posts for the retention feature to damage the tin plating of the through hole at the corner of engagement with the post, at least when the through hole is near one edge of the tolerance range. This problem has in the past limited the use of below the board retention features with stiff posts.

In the past, posts have been press fit into connector bodies such as pin headers. Pin headers often include either shrouded or shroudless plastic bodies which define preformed through holes into which the posts are press fit for retention in order to form a header assembly. The dimensions of the through holes and the posts are selected such that the corners of the posts interfere with the through holes, thereby retaining the posts in the connector body by a force fit.

In the past, problems have arisen during assembly of posts into such connector bodies. The assembly force required to push a post through a through hole may be undesirably high, and longer posts have experienced buckling due to excessively high assembly forces. Cracking of the plastic body of the connector has also occurred due to large interference forces, which may result in broken shrouds or loose posts. Additionally, plastic material may be skived or driven out of the through hole, accumulating on the tip of the post as it is pushed through the through hole. Such plastic material tends to accumulate on the post tip proper, and can lead to undesirable side effects when soldering the header assembly to a printed circuit board. Poor solder joints have been experienced.

The present invention is directed to an improved tip geometry that in the preferred embodiments described below, meets the following objectives:
(1) to reduce or eliminate the amount of plastic that is transferred to the tip of the post as the post is inserted into the connector body;
(2) to reduce the post assembly forces required to assemble the post in the connector body, thereby reducing or eliminating post buckling;
(3) to reduce the circumferential stresses on the through hole of the post body and to spread them more evenly, thereby reducing or eliminating breakage of the connector body;
(4) to provide better receptacle engagement surfaces on the mating end of the post, opposed to the solder end, thereby improving the feel of connector mating by reducing roughness and peak mating forces.

The present invention consists in an electrical connector as defined in claim 1.

An electrical connector according to the preamble of claim 1 is disclosed in EP-A-0 232 103.

There is described and claimed in EP-A-0 514 066 from which the present application has been divided an electrical connector of the type including a connector body and a plurality of posts extending out of one side of the connector body for mounting to a circuit board, each of said posts defining a tip, and a centerline, wherein the connector is mounted on a circuit board of the type comprising a pair of spaced, parallel surfaces and a plurality of through holes extending therebetween and intersecting the surfaces at corners, and wherein each of the posts is received in a respective one of the through holes, there being at least one retention feature, each formed on a selected one of the posts, said retention feature comprising a bent portion of the post comprising a first portion extending from the centerline to an apex, and a second portion extending from the apex to the tip, said retention feature being configured such that the apex is situated outside of the respective through hole, and the first portion contacts the circuit board at the respective corner between the through hole and the surface opposite the connector body; said second portion defining at least one contacting surface positioned to contact the circuit board at the respective corner between the through hole and the surface adjacent the connector body as the post is inserted into the respective through hole; characterized in that each of said posts defines two pairs of opposed flat faces and a maximum face to face cross sectional dimension, the second portion extending from the apex to the tip such that the apex is laterally offset from the centerline to a greater extent than is the tip, said contacting surface having a radius of curvature no less than about one fifth of the maximum face to face cross-sectional dimension of the post.

Embodiments of the present invention will now be described by way of example with reference to the accompanying drawings in which:
FIGURE 1 is a perspective view of a shrouded header assembly which incorporates a presently preferred embodiment of this invention;
FIGURE 2 is a top view of one of the through holes formed in the connector body of Figure 1;
FIGURE 3 is a cross sectional view taken along line 3-3 of Figure 2;
FIGURE 4 is a front view of one of the posts of the connector of Figure 1, mounted in a bandolier prior to insertion into the connector;
FIGURE 5 is an enlarged view of the encircled region 5 of Figure 4;
FIGURE 6 is a cross-sectional view taken along line 6-6 of Figure 4;
FIGURE 7 is a side view taken along line 7-7 of Figure 4;
FIGURE 8 is an enlarged view of the encircled region 8 of Figure 7;
FIGURE 9 is a perspective view of the tip geometry of one of the pins of Figures 5 and 7;
FIGURE 10 is an end view of the tip of the Figure 9;
FIGURE 11 is a perspective view of an alternative tip geometry suitable for use with the connector of Figure 1;
FIGURE 12 is an end view of the tip of Figure 11;
FIGURE 13 is an end view showing the configuration of the posts at one of the ends of the connector of Figure 1; and
FIGURE 14 is a cross sectional view showing the posts of Figure 13 engaged with a printed circuit board prior to soldering.

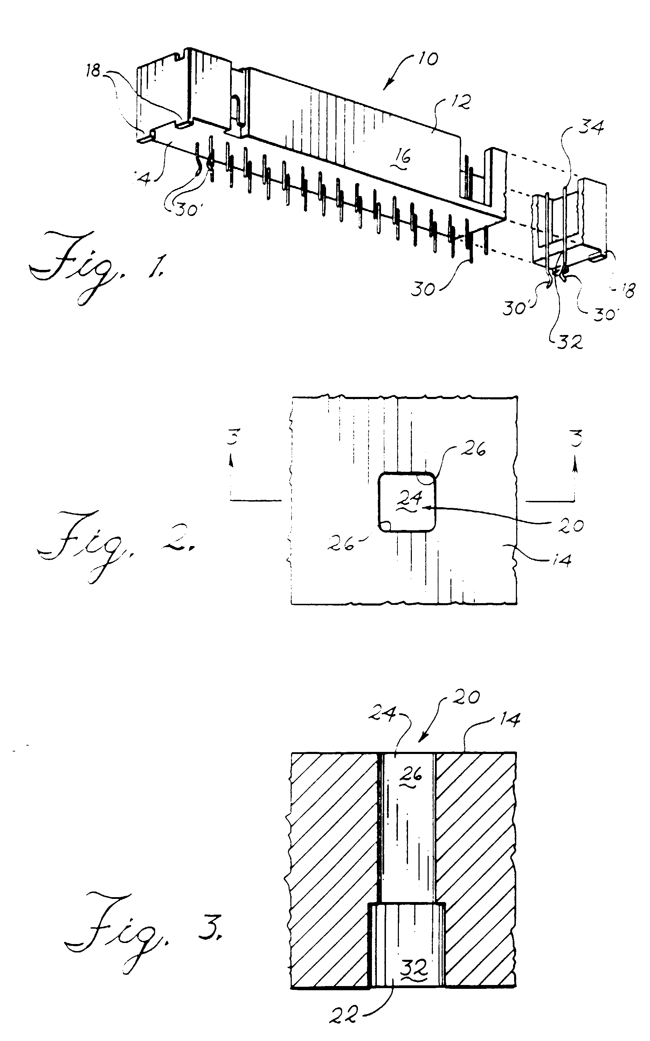

Turning now to the drawings, Figure 1 shows a general view of an electrical connector 10 which incorporates a presently preferred embodiment of this invention. The electrical connector 10 as shown is a header which comprises a connector body 12 molded of a suitable plastic material. The body 12 includes a base 14 and integrally molded side walls 16 and standoffs 18. Rows of through holes are preformed in the base 14 during the molding operation.

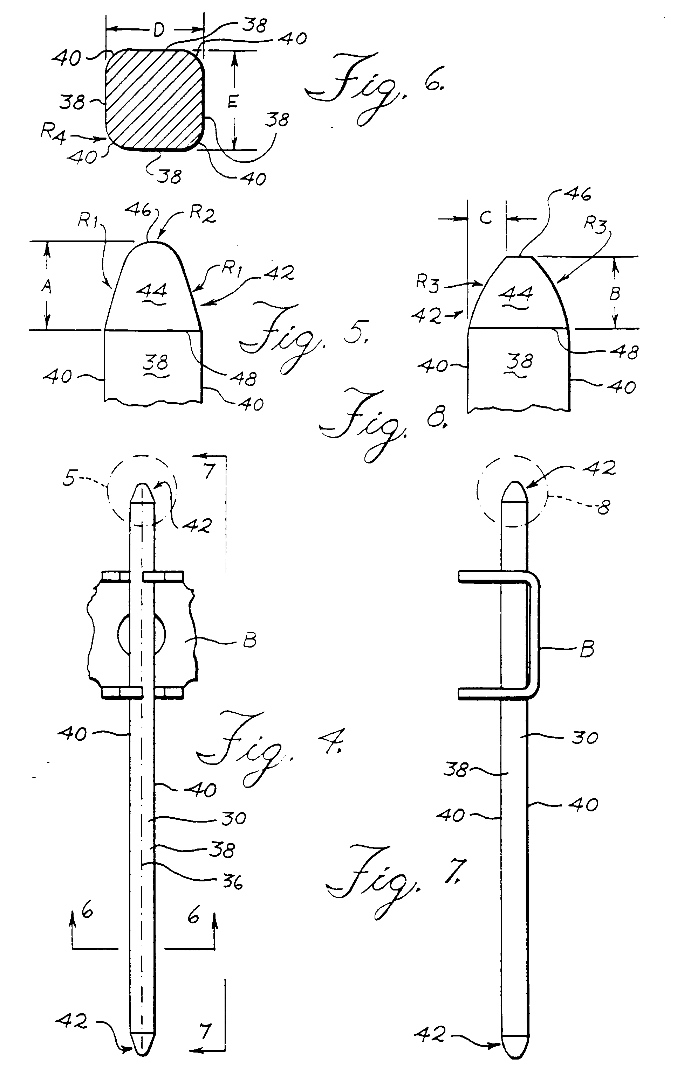

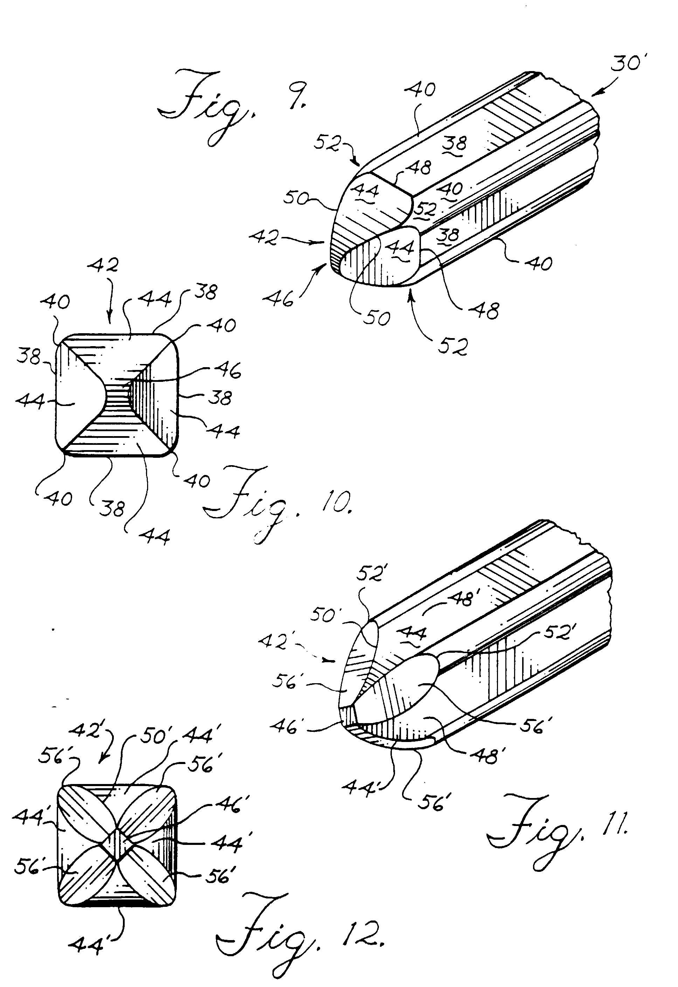

Figures 2 and 3 show further details of one of the through holes 20 of the base 14, which includes a round portion 22 and an out-of-round portion 24 that includes two pairs of opposed faces 26. Preferably, each through hole 20 is formed with a single core pin that forms both the round portion 22 and the out-of-round portion 24, thereby eliminating any internal mating lines (and possible misalignment) within the through hole 20.

As shown in Figure 1, the electrical connector 10 also includes an array of posts 30, 30'. Each of the posts 30, 30' defines a first end 32 and an opposed second end 34. The first ends 32 are adapted to be inserted into through holes of a printed circuit board while the second ends 34 are adapted to mate with a mating connector (not shown). In the connector 10, the four corner posts 30' are provided with a retention feature as described below.

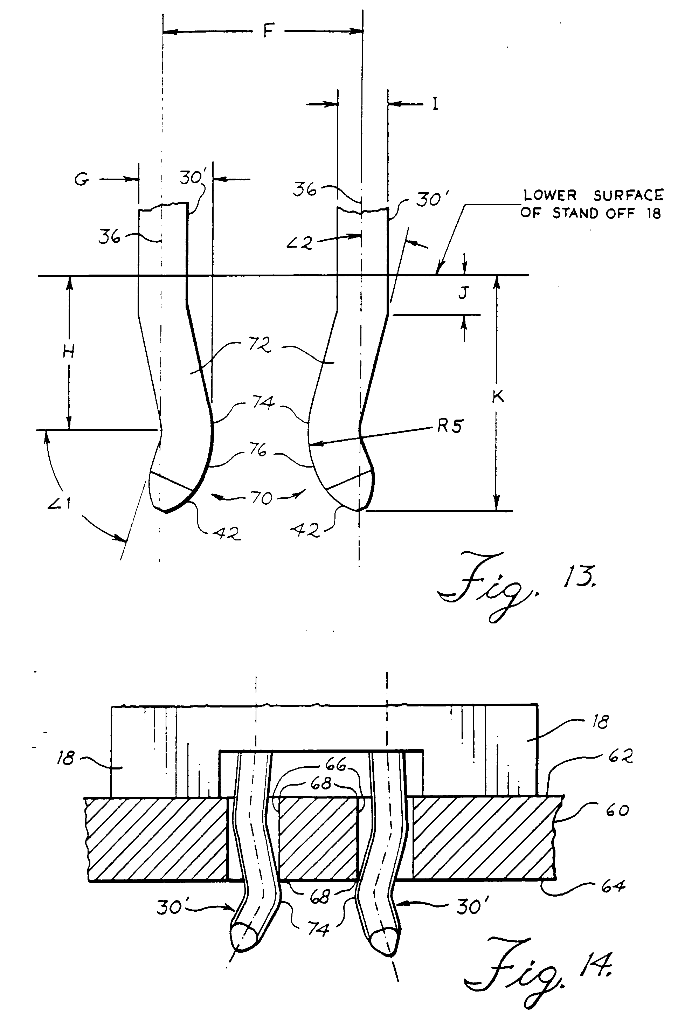

As shown in Figures 4, 6 and 7, each of the posts 30 defines a cross-section which comprises two pairs of opposed post faces 38 that intersect at post edges 40 extending parallel to the centerline 36. As shown in Figure 6, each of the post edges 40 is curved with a radius of curvature which is at least about one fifth of the maximum face to face dimension. In this particular embodiment, the maximum face to face dimension is about 0.0635cm (0.025 inches) and the radius of curvature is at least about 0.0127cm (0.005 inches). Figures 4 and 7 show one of the posts 30 mounted in a bandolier B which is used to position and retain the posts 30 for forming, plating and press fit operations in the conventional manner.

Each end of the posts 30, 30' defines a tip 42 which is shaped to provide the advantages described above. The features of the tip 42 described below facilitate insertion of the tip 42 into the through hole 20 and provide improved mating between the mating end and the socket of a mating connector (not shown).

In particular, as shown in Figures 5, 8, 9 and 10, each tip 42 defines four converging tip faces 44 which converge from the body of the post 30 toward a nose 46. The nose 46 may be flat or radiused as desired. In this embodiment each of the tip faces 44 is shaped as a section of a cylinder and is convex outwardly with a radius of curvature that is preferably greater than the maximum face to face dimension of the post 30. Each of the tip faces 44 is aligned with a respective one of the post faces 38 and is joined thereto at a tip-to-body edge 48. Because of the convexity of the tip faces 44, there is a smooth transition between each of the tip faces 44 and the aligned post face 38.

As best shown in Figures 9 and 10, adjacent ones of the tip faces 44 intersect at tip edges 50 which are convex outwardly and which intersect the radiused post edges 40 at tip-to-body corners 52. In this regard, the convexly shaped tip edges 50 cooperate with the radiused post edges 40 to provide a smooth transition and to substantially eliminate protruding corners that might tend to skive the through hole 20 of the body 12 during assembly.

Turning now to Figures 11 and 12, an alternative geometry for the tip 42' includes tip faces 44' substantially as described above which meet at a nose 46'. In this alternative embodiment intermediate surfaces 56' are provided which taper toward the nose 46'. Each of the intermediate surfaces 56' is interposed between two adjacent tip faces 44' such that the intermediate surfaces 56' are rotated by 45 degrees with respect to the tip faces 44'. In this embodiment the tip edges 50' curve inwardly toward the tip faces 44'.

The intermediate surfaces 56' provide a number of advantages. First, they reduce the prominence of the tip-to-body corners 52', thereby reducing skiving problems as described below. Furthermore, because the tip edges 50' curve inwardly toward the tip faces 44', debris tends to be wiped away to the outside of the tip 42' during mating. Furthermore, the shape of the tip faces 44' allows high pressure cleaning of a mating receptacle during mating. In alternative embodiments the tip faces 44' and the intermediate surfaces 56' may be all convex, all planar, or some may be convex and some planar.

In order to assemble the electrical connector 10 the posts 30 are press fit into the through holes 20 of the body 12, by passing the tips 42, 42' through the through holes 20 in a conventional press-fit operation. The tip geometries 42, 42' described above provide advantages during the press-fit operation. Because the tip-to-body corners 52, 52' and the tip-to-body edges 48, 48' are relieved, there is a reduced tendency for the tips 42, 42' to skive plastic out of the body 12 as the tips 42, 42' pass through the through hole 20. Because of the cooperation between the shape of the posts 30 and the shape of the through holes 20, maximum stresses on the body 12 around the through holes 20 are reduced, and maximum insertion forces are reduced as well. Furthermore, because the mating end 54 is shaped as described above, mating forces are reduced as well.

Once the electrical connector 10 has been assembled by press fitting the posts 30 into the body 12, a retention feature can be added to selected ones of the posts 30 to retain the electrical connector 10 temporarily in place in a circuit board prior to soldering. Figure 13 shows an enlarged end view of the connector 10 and two of the corner posts 30'. Figure 14 shows a cross-sectional view of the electrical connector 10 mounted in a circuit board 60 prior to soldering. The circuit board 60 defines top and bottom surfaces 62, 64 and through holes 66 extending therebetween. The through holes 66 are generally cylindrical, and the intersection region between the through holes 66 and the surfaces 62, 64 defines corners 68.

As shown in Figure 13, at least one and preferably pairs of the posts 30' are bent to provide a retention feature 70. The bent portion of each of the posts 30' defines a first portion 72 which diverges away from the centerline 36 to an apex 74. The bent post also defines a second portion 76 which extends from the apex 74 to the tip 42. As shown in Figure 13, the first and second portions 72, 76 are configured such that the apex 74 is positioned to one side of the centerline 36, but the tip 42 is positioned on the centerline 36. The radiused post edges 40 provide rounded contacting surfaces that contact the corners 68 as the retention feature 70 is inserted into the through hole 66. When the connector 10 is installed on the circuit board 60 (Figure 14), the apices 74 are positioned below the bottom surface 64. In this way, each of the retention features 70 creates a latching force tending to pull the electrical connector 10 into contact with the top surface 62.

Because the retention features 70 function below the board to latch the electrical connector 10 in place, an audible click may be heard when the electrical connector 10 is seated on the circuit board 60. Some users regard this latching type retention feature as more stable than retention features which rely solely on friction within the through hole 66. The retention feature 70 has surprisingly been found to function properly with circuit board through holes 66 having a wide range of diameters, without unacceptable damage to the tin plating that is typically present in the through hole. This surprising result is believed to be directly attributable to the cooperation between the geometry of the first and second portions 72, 76 and the geometry of the radiused post edges 40. The resulting retention feature reduces damage to the through hole plating and functions without any undesirable increase in the length of the post 30' extending below the bottom surface 64 of the circuit board 60.

The retention feature 70 can be used both with straight headers as shown and right angle headers (not shown). Furthermore, the retention feature 70 can be used on single posts or on pairs of posts as shown in which the apex is 74 offset with respect to the centerline 36. Depending upon the application, the apexes 74 may be offset toward one another, away from one another, or at some angle with respect to one another. Furthermore, the retention feature 70 is well suited for use in headers having one, two, or three or more rows of posts 30.

Simply by way of example, the following details of construction have been found suitable in one application. Of course, these details are not intended to limit the scope of this invention, because other applications will often require other specific geometries or materials.

With respect to materials, the posts 30, 30' may be formed from drawn, radiused phosphor bronze wire such as UNS C51000, Temper 3H. The body 12 may be molded of any suitable material such as a glass filled nylon or a liquid crystal polymer.

With respect to dimensions, Table 1 provides presently preferred dimensions, using reference symbols defined in Figures 5, 6, 8 and 13.

**TABLE 1**

| Reference Symbol (Figures ) | Dimension cms (inches) Or Angle degrees | |
|---|---|---|
| A | 0.05842 | (0.023) |
| B | 0.04572 | (0.018) |
| C | 0.02413 | (0.0095) |
| D | 0.06452 | (0.0245) |
| E | 0.06452 | (0.0245) |
| F | 0.254 | (0.100) |
| G | 0.09652 | (0.038) |
| H | 0.19558 | (0.077) |
| I | 0.06452 | (0.0245) |
| J | 0.0508 | (0.020) |
| K | 0.29718 | (0.117) |
| L₁ | | 70° 46 |
| L₂ | | 13° 35 |
| R₁ | 0.3302 | (0.130) |
| R₂ | 0.01778 | (0.007) |
| R₃ | 0.09398 | (0.037) |
| R₄ | 0.01524 | (0.006) |
| R₅ | 0.1784 | (0.055) |

Note that the length of the tip A is less than the maximum face to face dimension D, E.

The round portion 22 in this preferred embodiment has a diameter of 0.07036cm (0.0277 inches), and the out-of-round portion 24 in this preferred embodiment defines a maximum diagonal dimension of 0.07036cm (0.0277 inches), and a maximum dimension between opposed faces 26 of 0.05969 cm (0.0235) inches). The posts 30, 30' define a maximum diagonal dimension of 0.074168cm (0.0292 inches). These dimensions have been found to provide excellent post retention without excessive post insertion forces or excessive stresses to the body 12.

Preferably, the tip 42 is formed in a multi-step operation which combines coining and shearing operations, using vertically moving dies. In the first step an upper one of the tip faces 44 in coined downwardly. This pushes excess metal laterally. Then the two side tip faces 44 shown in profile in Figure 5 are sheared into the desired convex shape. Finally, the upper and lower tip faces shown in profile in Figure 8 are coined (the upper tip face for the second time and the lower tip face for the first time) to the final convex shape. This approach provides the desired tip geometry while requiring only dies that move vertically.

The first ends 32 are typically tin plated to facilitate soldering, and the second ends 34 are typically gold plated to facilitate mating operations. However, plating details for the first and second ends do not form part of this invention, and are therefore not described in greater detail here.

This preferred embodiment has been designed for use with through holes 66 having a diameter of 0.1016 cm ± 0.00762 cm (0.040 ± 0.003 inches) in a circuit board 60 having a thickness of 0.15748 cm ± 0.01778 cm (0.062 ± 0.007 inches). Throughout these tolerance ranges the connector 10 can be inserted with an insertion force of no more than 4.54 kg (10 pounds), and adequate retention forces are obtained. Surprisingly, this has been achieved with stiff posts of the type described above, without damage to the tin plating at the corners 68.

The present invention may readily be adapted to square posts of other dimensions and to rectangular posts. Other forming techniques such as rolling and cutting operations may be used to form the tip, and the radiused post edges may be compressively or otherwise formed only in desired regions of the post.

## Claims

1. An electrical connector (10) of the type including a connector body (12) and at least one post (30,30') extending out of at least one side of the connector body (12), wherein the post has a tip, two pairs of opposed post faces (38) that intersect at rounded edges extending along the post, and a maximum face to face dimension between two of the opposed post faces characterised in that the tip comprises four tip faces (44) which converge toward a tip nose (46), each tip face being aligned with a respective one of the post faces (38), and in that at least one of the tip faces (44) is convex outwardly, and the edges between the post faces (38) adjacent to the tip (42) are curved with a radius of curvature greater than about one fifth the maximum face to face dimension.

2. An electrical connector (10) as claimed in claim 1, wherein the opposed post faces (38) in each pair are separated by an equal distance.

3. An electrical connector (10) as claimed in claim 2, wherein the opposed post faces in each pair are separated by about 0.0635 cm (0.025 inches), and wherein the radius of curvature is greater than about 0.0127 cm (0.005 inches).

4. An electrical connector (10) as claimed in claim 1, 2 or 3, wherein the tip faces (44) are each convexly curved with a radius of curvature greater than the maximum face to face dimension.

5. An electrical connector (10) as claimed in claim 1, 2, 3 or 4 wherein the edges between the post faces are curved with a radius of curvature of about 0.01524cm (0.006 inches).

6. An electrical connector (10) as claimed in any preceding claim, wherein the tip (42) defines a length, and wherein the length is less than the maximum face to face dimension.

7. An electrical connector as claimed in any preceding claim, wherein the post (30,30') defines a mating end (34), opposed to the tip, for interconnection with a mating connector, and wherein the mating end (34) defines four additional tip faces which converge toward the mating end, each additional tip face being aligned with a respective one of the post faces (38), at least one additional tip face being convex outwardly, each of the edges between the post faces (38) adjacent to the mating end (34) being curved with a radius of curvature greater than about one-fifth the maximum face to face dimension

8. An electrical connector as claimed in any preceding claim, wherein the connector body (12) defines preformed through holes (66) which receive the posts (30,30'), wherein the preformed through holes (66) define two portions of different cross-sectional dimensions, and wherein the preformed through holes (66) are free of internal mating lines.

## Patentansprüche

1. Elektrischer Verbinder (10) der Art mit einem Verbinderkörper (12) und mindestens einem sich aus mindestens einer Seite des Verbinderkörpers (12) erstreckenden Stift (30, 30'), wobei der Stift eine Spitze, zwei Paare gegenüberliegender Stiftflächen (38), die sich an sich entlang dem Stift erstreckenden abgerundeten Rändern schneiden, und eine maximale Flächen-Flächen-Abmessung zwischen zwei der einander gegenüberliegenden Stiftflächen aufweist, dadurch gekennzeichnet, daß die Spitze vier Spitzenflächen (44) umfaßt, die zu einer Spitzennase (46) aufeinander zulaufen, wobei jede Spitzenfläche zu einer entsprechenden der Stiftflächen (38) ausgerichtet ist, und daß mindestens eine der Spitzenflächen (44) nach außen konvex ist, und die Ränder zwischen den Stiftflächen (38) neben der Spitze (42) mit einem größeren Krümmungsradius als rund ein Fünftel der maximalen Flächen-Flächen-Abmessung gekrümmt sind.

2. Elektrischer Verbinder (10) nach Anspruch 1, wobei die einander gegenüberliegenden Abstiftflächen (38) in jedem Paar durch einen gleichen Abstand voneinander getrennt sind.

3. Elektrischer Verbinder (10) nach Anspruch 2, wobei die einander gegenüberliegenden Stiftflächen in jedem Paar um rund 0,0635 cm (0,025 Zoll) voneinander getrennt sind und wobei der Krünmungsradius größer als rund 0,0127 cm (0,005 Zoll) beträgt.

4. Elektrischer Verbinder (10) nach Anspruch 1, 2 oder 3, wobei die Stiftflächen (44) jeweils mit einem größeren Krümmungsradius als die maximale Flächen-Flächen-Abmessung konvex gekrümmt sind.

5. Elektrischer Verbinder (10) nach Anspruch 1, 2, 3 oder 4, wobei die Ränder zwischen den Stiftflächen mit einem Krümmungsradius von rund 0,01524 cm (0,006 Zoll) gekrümmt sind.

6. Elektrischer Verbinder (10) nach einem der vorhergehenden Ansprüche, wobei die Spitze (42) eine Länge definiert und wobei die Länge geringer als die maximale Flächen-Flächen-Abmessung ist.

7. Elektrischer Verbinder nach einem der vorhergehenden Ansprüche, wobei der Stift (30, 30') ein der Spitze gegenüberliegendes Paßende (34) zur Verbindung mit einem paarigen Verbinder definiert und wobei das Paßende (34) vier zusätzliche Spitzenflächen definiert, die zum Paßende zu aufeinander zulaufen, wobei jede zusätzliche Spitzenfläche zu einer entsprechenden der Stiftflächen (38) ausgerichtet ist, wobei mindestens eine zusätzliche Spitzenfläche nach außen konvex ist, wobei jeder der Ränder zwischen den dem Paßende (34) benachbarten Stiftflächen (38) mit einem größeren Krümmungsradius als rund einem Fünftel der maximalen Flächen-Flächen-Abmessung gekrümmt ist.

8. Elektrischer Verbinder nach einem der vorhergehenden Ansprüche, wobei der Verbinderkörper (12) vorgeformte Durchgangslöcher (66) definiert, die die Stifte (30, 30') aufnehmen, wobei die vorgeformten Durchgangslöcher (66) zwei Teile mit unterschiedlichen Querschnittsabmessungen definieren und wobei die vorgeformten Durchgangslöcher (66) von internen Paßlinien frei sind.

## Revendications

1. Connecteur électrique (10) du type comprenant un corps (12) de connecteur et au moins une broche (30, 30') se prolongeant à l'extérieur d'au moins un côté du corps (12) de connecteur, dans lequel la broche présente une pointe, deux paires de faces opposées (38) de broche qui s'intersectent suivant des bords arrondis se prolongeant le long de la broche, et une dimension maximale entre faces, entre deux faces opposées de broche, caractérisé en ce que la pointe comprend quatre faces (44) de pointe qui convergent vers un nez (46) de pointe, chaque face de pointe étant alignée avec une face respective des faces (38) de broche, et en ce qu'au moins une des faces (44) de pointe est convexe vers l'extérieur, et les bords entres les faces (38) de broche adjacents à la pointe (42) sont incurvés à un rayon de courbure supérieur à environ un cinquième de la dimension maximale entre faces.

2. Connecteur électrique (10) selon la revendication 1, dans lequel les faces opposées (38) de broche dans chaque paire sont séparées d'une distance égale.

3. Connecteur électrique (10) selon la revendication 2, dans lequel les faces opposées (38) de broche dans chaque paire sont séparées d'environ 0,0635 cm (0,025 pouce), et dans lequel le rayon de courbure est supérieur à environ 0,0127 cm (0,005 pouce).

4. Connecteur électrique (10) selon la revendication 1, 2 ou 3, dans lequel les faces (44) de pointe sont chacune incurvées, de manière convexe, à un rayon de courbure supérieur à la dimension maximale entre faces.

5. Connecteur électrique (10) selon la revendication 1, 2, 3 ou 4, dans lequel les bords entre les faces de broche sont incurvés à un rayon de courbure d'environ 0,01524 cm (0,006 pouce).

6. Connecteur électrique (10) selon l'une quelconque des revendications précédentes, dans lequel la pointe (42) définit une longueur, et dans lequel la longueur est inférieure à la dimension maximale entre faces.

7. Connecteur électrique (10) selon l'une quelconque des revendications précédentes, dans lequel la broche (30, 30') définit une extrémité d'accouplement (34), opposée à la pointe, en vue d'une interconnexion avec un connecteur d'accouplement, et dans lequel l'extrémité d'accouplement (34) définit quatre faces de pointe supplémentaires qui convergent vers l'extrémité d'accouplement, chaque face de pointe supplémentaire étant alignée avec une face respective des faces (38) de broche, au moins une face de pointe supplémentaire étant convexe vers l'extérieur, chacun des bords entre les faces (38) de broche adjacents à l'extrémité d'accouplement (34) étant incurvé à un rayon de courbure supérieur à environ un cinquième de la dimension maximale entre faces.

8. Connecteur électrique selon l'une quelconque des revendications précédentes, dans lequel le corps (12) de connecteur définit des trous traversants préformés (66) qui reçoivent les broches (30, 30'), dans lequel les trous traversants préformés (66) définissent deux portions de dimensions différentes en section transversale, et dans lequel les trous traversants préformés (66) sont exempts de lignes de joint internes.
